Europäisches Patentamt

European Patent Office

Office européen des brevets

(19)

(11) **EP 0 462 495 B1**

(12) **EUROPÄISCHE PATENTSCHRIFT**

(45) Veröffentlichungstag und Bekanntmachung des Hinweises auf die Patenterteilung:
**11.09.1996 Patentblatt 1996/37**

(51) Int Cl.6: **H03M 3/02**, H03D 3/00, H03D 1/22, H03M 1/20

(21) Anmeldenummer: **91109596.6**

(22) Anmeldetag: **12.06.1991**

(54) **Ein vereinfachter interpolativer Analog/Digital-Umsetzer für Bandpass-Signale**

Simplified interpolative analog-digital converter for bandpass signals

Convertisseur analogique-numérique interpolatif simplifié pour signaux de bande-passante

(84) Benannte Vertragsstaaten:
**DE FR GB IT SE**

(30) Priorität: **21.06.1990 DE 4019726**

(43) Veröffentlichungstag der Anmeldung:
**27.12.1991 Patentblatt 1991/52**

(73) Patentinhaber: **AEG MOBILE COMMUNICATION GmbH**
**D-89081 Ulm (DE)**

(72) Erfinder: **Dressler, Hans-Joachim**
**W-7900 Ulm (DE)**

(74) Vertreter: **Körner, Ekkehard, Dipl.-Ing. et al**
**Patentanwalt**
**Maximilianstrasse 58**
**80538 München (DE)**

(56) Entgegenhaltungen:
**EP-A- 0 119 529**

- **ELECTRONICS LETTERS Bd. 25, Nr. 23, 9. November 1989, STEVENAGE, HERTS, GB Seiten 1560 - 1561 , XP000073345 SCHREIER 'BANDPASS SIGMA-DELTA MODULATION'**
- **SIGNAL PROCESSING Bd. 22, Nr. 2, Februar 1991, AMSTERDAM, NL Seiten 139 - 151 , XP000208672 DRESSLER 'INTERPOLATIVE BANDPASS A/D CONVERSION'**

**Beschreibung**

Die Erfindung bezieht sich auf einen interpolativen A/D-Umsetzer zum Digitalisieren von analogen Bandpaß-Signalen nach dem Oberbegriff des Anspruchs 1, insbesondere für die Trägerfrequenz oder Zwischenfrequenz in Funkempfängern. Die Digitalisierung minimiert den Schaltungsaufwand an der Analog/Digital-Schnittstelle und umgeht die Schwierigkeiten, die bei analogen Lösungen durch nichtideale Bauelement-Eigenschaften auftreten. Aus der Anmeldung DE P 39 43 072.3 der gleichen Anmelderin ist bereits eine interpolative A/D-Umsetzung von Bandpaß-Signalen bekannt.

Bei Anwendungsfällen, bei denen die Trägerlage größer bis sehr viel größer ist als die Abtastfrequenz, kann es zu Realisierungsproblemen kommen. Dies liegt an der erforderlichen Mindestgüte der bisher benötigten Bandpaß-Integratoren, die einen oder mehrere Schwingkreise besitzen, deren Resonanzfrequenzen auf die Trägerfrequenz des analogen Bandpaß-Signals abgestimmt sind. Dabei ist der lineare Zusammenhang zwischen der Mindestgüte und der Trägerfrequenz zu beachten, d.h. je höher die Frequenz, umso höher muß die Mindestgüte sein.

In ELECTRONICS LETTERS, Bd. 25, Nr. 23, 9. November 1989, STEVENAGE, HERTS, GB, Seiten 1560 - 1561, SCHREIER 'BANDPASS SIGMA-DELTA MODULATION' wird die theoretische Grundlage für den Entwurf von Filtern in interpolativen Analog/Digital-Umsetzern für Bandpaß-Signale dargestellt.

Der Erfindung liegt daher die Aufgabe zugrunde, einen interpolativen A/D-Umsetzer für Bandpaß-Signalen anzugeben, bei dem die Güteanforderungen an die Schwingkreise geringer sind als bei den bereits bekannten umsetzern. Diese Aufgabe wird durch die Merkmale des Anspruchs 1 gelöst. Vorteilhafte Ausgestaltungen und/oder Weiterbildungen sind den Unteransprüchen entnehmbar.

Nach dem bisher bekannten Ansatz zur interpolativen A/D-Umsetzung von Bandpaß-Signalen wird im Analogteil des A/D-Umsetzers ein Bandpaß-Integrator benötigt, dessen Resonanzfrequenz $f_{r,n}$ auf die Trägerlage $f_m$ des Bandpaß-Signals abgestimmt ist:

$$f_{r,n=m} = f_m = \frac{2m+1}{4} f_a$$

wobei $f_a$ die Abtastfrequenz bezeichnet.

Die erfindungsgemäßen Vereinfachungen ergeben sich aus den Eigenschaften realer Bandpaß-Integratoren. Die Selektivität eines Bandpaß-Integrators ist schmalbandig betrachtet, d.h. in unmittelbarer Nähe seiner Resonanzfrequenz, vor allem durch die Güte der verwendeten Resonatoren bestimmt. Während die 3-dB-Bandbreite $F_{3dB}$ eines idealen Bandpaß-Integrators verschwindet, nimmt die 3-dB-Bandbreite eines realen Bandpaß-Integrators einen endlichen Wert an. Dieser sollte weit unter der Bandbreite des Eingangssignals $B_{3dB}$ liegen. Als Richtwert gilt

$$F_{3dB} < \frac{1}{4} B_{3dB} \cdot \qquad (1)$$

Diese Forderung führt mit zunehmendem $m$ zu Güteanforderungen, die nur mit hohem Aufwand, in Extremfällen gar nicht realisierbar sind.

Werden nun Bandpaß-Integratoren eingesetzt, die die erforderliche Mindestgüte nicht erreichen, wird der A/D-Umsetzer durchaus nicht unbrauchbar. Es verringert sich lediglich die Amplitudenauflösung des A/D-Umsetzers. Dieser Verlust kann auch je nach Bedarf durch Erhöhung des überabtastfaktors jederzeit wieder kompensiert werden, was dann aber aufwendigere Digitalfilter erfordert.

Nachdem also auch größere Bandbreiten $F_{3dB}$ als nach (1) vorgegeben zulässig sind, soll nun der Fall

$$F_{3dB} \approx B_{3dB}$$

betrachtet werden. Aus dieser Beziehung folgt, daß die Filterwirkung des Bandpaß-Integrators auf das schmalbandige Eingangssignal gering ist. Das Übertragungsverhalten der ersten Stufe ändert sich also nur geringfügig, wenn die Bandpaß-Integration des Eingangssignals vernachlässigt wird. Die dadurch eingeführte lineare Verzerrung des Eingangssignals läßt sich in Stufe 2 nachholen.

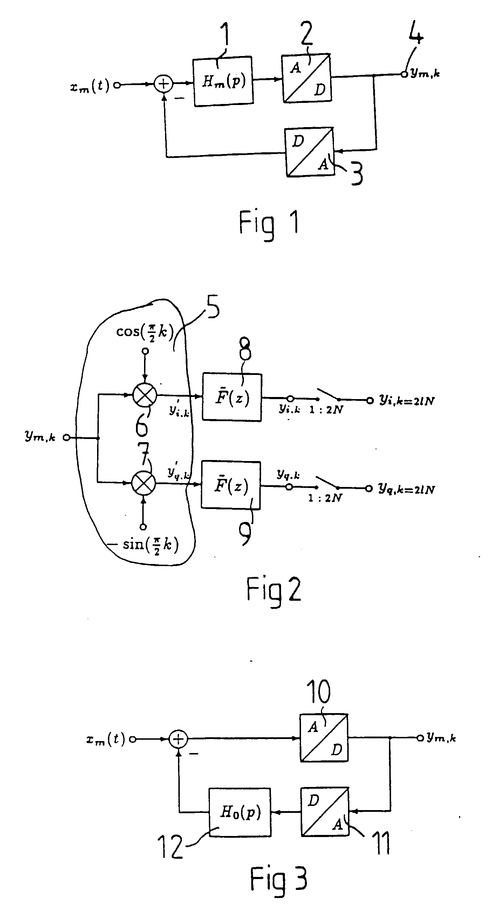

Es genügt also, wie in Fig. 3 angedeutet, sich auf die Bandpaß-Integration des Rückkopplungssignals zu beschränken. Die entscheidende Vereinfachung ergibt sich nun aus der spektralen Periodizität des Rückkopplungssignals. Dabei sei daran erinnert, daß das Rückkopplungssignal durch D/A-Umsetzung aus einem Digitalsignal gebildet wird. Da digitale Signale bekanntlich periodische Spektren besitzen und die D/A-Umsetzung lediglich einer spektralen Gewichtung des Digitalsignals entspricht (z.B. sin(x)/x-Gewichtung), besitzt auch das resultierende Analogsignal noch ein quasi-periodisches Spektrum, d.h. die im Rückkopplungssignal enthaltene Information erscheint an unendlich vielen, aber diskreten Stellen im Spektrum. Es sind dies die Frequenzen

$$f_n = \frac{2n+1}{4} f_a \text{ (n=0,1,2,...)}.$$

Als Resonanzfrequenz $f_{r,n}$ zur Bandpaß-Integration kommt folglich nicht nur die Trägerlage $f_m$ des Eingangssignals, sondern alle periodisch mit der Abtastfrequenz $f_a$ fortgesetzten Frequenzen

$$f_{r,n} = f_n = \frac{2n+1}{4} f_a$$

für n=0;1;2;3;... in Frage.

Zur Minimierung des Realisierungsaufwandes wird n=0 vorgeschlagen, da hier die Güteanforderungen am geringsten sind. Die Erfindung wird im folgenden anhand der Figuren näher erläutert:

Fig. 1   zeigt den Analogteil (1. Stufe) des bekannten interpolativen Bandpaß-A/D-Umsetzers,

Fig. 2   zeigt den Digitalteil (2. Stufe) des bekannten interpolativen Bandpaß-A/D-Umsetzers,

Fig. 3 zeigt den Analogteil des erfindungsgemäßen Bandpaß-A/D-Umsetzers,

Fig. 4 zeigt den Digitalteil des erfindungsgemäßen Bandpaß-A/D-Umsetzers.

Der Analogteil des bekannten interpolativen Bandpaß-A/D-Umsetzers in Fig. 1, bestehend aus dem Bandpaß-Integrator 1, dessen Resonanzfrequenz fr gleich der Trägerlage $f_m$ des Bandpaß-Signals ist, dem A/D-Umsetzer 2 und dem D/A-Umsetzer 3. Bei Einhaltung der Bedingung

$$f_m = \frac{2m+1}{4} \, f_a \qquad (2)$$

und

$$f_a > 2NB \qquad (3)$$

wobei B die Bandbreite des zu wandelnden Bandpaß-Signals und N>>1, wird das Quantisierungsrauschen spektral so gefärbt, daß es im wesentlichen außerhalb des Nutzfrequenz-Bereichs liegt.

In dem in Fig. 2 dargestellten Digitalteil des bekannten interpolativen Bandpaß-A/D-Umsetzers werden die am Ausgang der ersten Stufe 4 anliegenden Signale im Quadraturmischer 5 mit dem Digitalmultiplizierer 6 mit cos ($\pi$/2·k) multipliziert und anschließend durch den digitalen Tiefpaß 8 geschickt, dessen Durchlaßbereich der Bandbreite des dem Bandpaß-Signal äquivalenten Tiefpaß-Signals (Grenzfrequenz fg=B/2) angepaßt ist, so daß an dessen Ausgang der feinquantisierte Realteil des äquivalenten Tiefpaß-Signals zur Verfügung steht. Ebenso wird das am Ausgang der ersten Stufe 4 anliegende Signal im Quadraturmischer 5 mit Digitalmultiplizierer 7 mit -sin ($\pi$/2·k) multipliziert und dann durch den digitalen Tiefpaß 9 geschickt, dessen Durchlaßbereich mit dem digitalen Tiefpaß 8 übereinstimmt, so daß im Ausgang des digitalen Tiefpaß 9 der feinquantisierte Imaginärteil des äquivalenten Tiefpaß-Signals zur Verfügung steht.

In Fig. 3 erkennt man, daß das zu wandelnde Bandpaß-Signal direkt vom A/D-Umsetzer 10 mit der Frequenz $f_a > 2NB$ (Gleichung 3) gewandelt wird. Im Rückkopplungsteil wird die so entstandene digitale Folge im D/A-Umsetzer 11 mit derselben Frequenz zurückgewandelt und mit dem Bandpaß-Integrator die Bandpaß-Integration durchgeführt. Für die Resonanzfrequenz des Bandpaß-Integrators gilt:

$$f_{r,n} = \frac{2n+1}{4} \, f_a$$

für n=0;1;2;3...

Bevorzugt ist n=0 zu verwenden, da hier die Güteanforderungen für den Bandpaß-Integrator am niedrigsten sind.

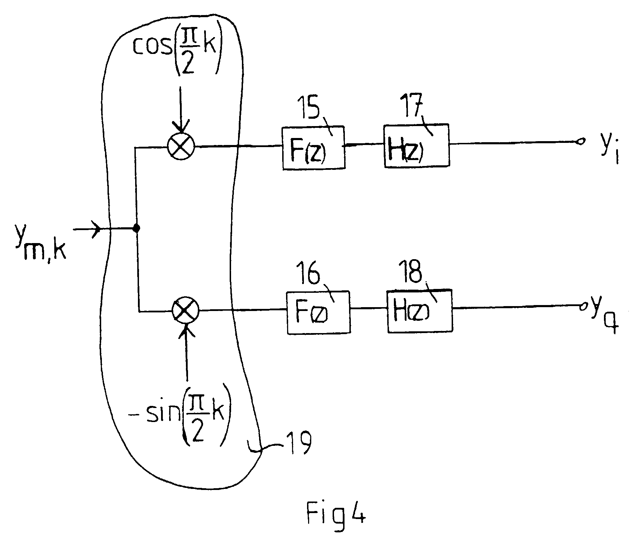

Der in Fig. 4 dargestellte Digitalteil des erfindungsgemäßen interpolativen A/D-Umsetzers für Bandpaß-Signale enthält den Quadraturmischer 19, der in Aufbau und Funktion dem Quadraturmischer 5 in Fig. 2 entspricht. Dies gilt auch für die beiden Digitalfilter 15 und 16, die den Digitalfiltern 8 und 9 in Fig. 2 entsprechen. Die dargestellten Digitalfilter 17 und 18 sind dem Bandpaß-Integrator 1 äquivalente Tiefpaß-Integratoren. Bei einer Bandpaß-Integration erster Ordnung lauten die übertragungsfunktionen der äquivalenten Tiefpässe:

$$H(z) = \frac{z}{z-a} \, ,$$

wobei a < 1 entsprechend der Güte des analogen Bandpaßintegrators einzustellen ist.

**Patentansprüche**

1. Interpolativer Analog/Digital-Umsetzer für Bandpaß-Signale, bestehend aus zwei Stufen, dadurch gekennzeichnet, daß in der ersten Stufe, d.h. im Analogteil des Umsetzers, die Bandpaß-Integration nur im Rückkopplungszweig durchgeführt wird, und die so unterlassene Bandpaß-Integration des Eingangssignals in der zweiten Stufe d.h. im Digitalteil des Umsetzers, durchgeführt wird.

2. Interpolativer Analog/Digital-Umsetzer für Bandpaß-Signale nach Anspruch 1, dadurch gekennzeichnet, daß der Bandpaß-Integrator (12) im Rückkopplungszweig die Resonanzlage $f_r = ¼f_a$ besitzt.

3. Interpolativer Analog/Digital-Umsetzer für Bandpaß-Signale nach Anspruch 1 oder 2, dadurch gekennzeichnet, daß die Bandpaß-Integration des Eingangssignals in der zweiten Stufe (Digitalteil) nach digitaler Quadraturdemodulation im Inphasen- und Quadraturzweig mit jeweils einem Integrator herkömmlicher Art, d.h. einem Tiefpaß-Integrator, durchgeführt wird.

**Claims**

1. An interpolative analog-digital converter for bandpass signals, comprising two stages, characterised in that in the first stage, i.e. in the analog portion of the converter, the bandpass integration is only performed in the feedback branch, and the bandpass integration omitted thereby of the input signal is performed in the second stage, i.e. in the digital portion of the converter.

2. The interpolative analog-digital converter for bandpass signals as set forth in claim 1, characterised in that the bandpass integrator (12) in the feedback branch has the resonance condition $f_r = ¼f_a$.

3. The interpolative analog-digital converter for bandpass signals as set forth in claim 1 or claim 2, characterised in that the bandpass integration of the input signal is performed in the second stage (digital portion) after digital quadrature demodulation in the in-phase branch and the quadrature branch each with a conventional integrator, i.e. a lowpass integrator.

**Revendications**

1. Convertisseur analogique/numérique interpolatif pour signaux de bande passante, constitué de deux étages, caractérisé en ce que, dans le premier étage, c'est-à-dire dans la partie analogique du convertisseur, l'intégration de bande passante n'est exécutée que dans la branche de rétroaction et l'intégration de bande passante du signal d'entrée qui est ainsi omise est exécutée dans le second étage, c'est-à-dire dans la partie numérique du convertisseur.

2. Convertisseur analogique/numérique interpolatif pour signaux de bande passante selon la revendication 1, caractérisé en ce que l'intégrateur passebande (12) situé dans la branche de rétroaction possède le niveau de résonance fr = ¼ . fa.

3. Convertisseur analogique/numérique interpolatif pour signaux de bande passante selon la revendication 1 ou 2, caractérisé en ce que l'intégration de bande passante du signal d'entrée est exécutée dans le second étage (partie numérique) suivant une démodulation de quadrature numérique dans la branche en phase et la branche de quadrature avec dans chaque cas un intégrateur d'un type classique, c'est-à-dire un intégrateur passe-bas.

Fig 1

Fig 2

Fig 3

5

$$\cos\left(\frac{\pi}{2}k\right)$$

Fig 4